(19) Europäisches Patentamt
European Patent Office
Office européen des brevets

(11) Veröffentlichungsnummer: **0 355 335 B1**

(12) **EUROPÄISCHE PATENTSCHRIFT**

(45) Veröffentlichungstag der Patentschrift: **14.04.93**

(51) Int. Cl.[5]: **G03C 1/73**, C09B 11/12

(21) Anmeldenummer: **89112037.0**

(22) Anmeldetag: **01.07.89**

# (54) Lichtempfindliches Aufzeichnungsmaterial, dessen Verwendung und dafür geeignete neue Leukoverbindung.

(30) Priorität: **20.07.88 DE 3824551**

(43) Veröffentlichungstag der Anmeldung:
**28.02.90 Patentblatt 90/09**

(45) Bekanntmachung des Hinweises auf die Patenterteilung:
**14.04.93 Patentblatt 93/15**

(84) Benannte Vertragsstaaten:
**AT BE CH DE ES FR GB IT LI NL SE**

(56) Entgegenhaltungen:
**DE-A- 3 433 026**
**GB-A- 2 131 042**
**US-A- 3 445 234**
**US-A- 3 666 466**
**US-A- 4 017 313**
**US-A- 4 622 286**

(73) Patentinhaber: **BASF Aktiengesellschaft**
**Carl-Bosch-Strasse 38**
**W-6700 Ludwigshafen(DE)**

(72) Erfinder: **Aldag, Reinhard, Dr.**
**Beckstrasse 23**
**W-6930 Eberbach(DE)**
Erfinder: **Seitz, Friedrich, Dr.**
**Von-Wieser-Strasse 1**
**W-6701 Friedelsheim(DE)**
Erfinder: **Bluemel, Thomas, Dr.**
**An der Bleiche 12 a**
**W-6701 Erpolzheim(DE)**
Erfinder: **Hoffmann, Gerhard, Dr.**
**Pappelstrasse 22**
**W-6701 Otterstadt(DE)**
Erfinder: **Huemmer, Wolfgang, Dr.**
**Vischerstrasse 16**
**W-6703 Limburgerhof(DE)**
Erfinder: **Neumann, Peter, Dr.**
**Poststrasse 28**
**W-6800 Mannheim 31(DE)**

EP 0 355 335 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft lichtempfindliche Aufzeichnungsmaterialien zur silberfreien Bilderzeugung, im wesentlichen bestehend aus einem Gemisch aus

(a) einem oder mehreren filmbildenden polymeren Bindemitteln,

(b) einem Farbbildnersystem,

(c) gegebenenfalls einer oder mehreren monomeren Verbindungen mit mindestens einer polymerisierbaren, ethylenisch ungesättigten Doppelbindung,

(d) gegebenenfalls einem durch Bestrahlung aktivierbaren Photoinitiator oder Photoinitiatorsystem und

(e) üblichen Zusatz- und Hilfsstoffen,

wobei das Farbbildnersystem ein Photooxidationsmittel, eine Leukoverbindung mit hoher Lagerstabilität und gegebenenfalls einen Sensibilisator enthält. Die erfindungsgemäßen Bilderzeugungsmaterialien sind besonders für die Verwendung in Hochdruckplatten, Tiefdruckplatten, Flachdruckplatten oder Photoresistfilmen geeignet, wie sie beispielsweise in der Zeitschrift Angewandte Chemie, 94 (1982), 471 beschrieben werden.

Lichtempfindliche Aufzeichnungsmaterialien für die Bilderzeugung und die genannten Anwendungszwecke sind an sich bekannt. Sie enthalten im allgemeinen neben einer photopolymerisierbaren, olefinisch ungesättigten organischen Verbindung, einem polymeren Bindemittel sowie einem Photopolymerisationsinitiator ein farbbildendes System, welches bei Bestrahlung mit aktinischem Licht in den bestrahlten Bereichen eine Farbänderung bewirkt. Diese Farbänderung ist für die visuelle Beurteilung und Kontrolle der Aufzeichnungsmaterialien nach der bildmäßigen Belichtung von großer Wichtigkeit. So ist es z.B. bei der Herstellung gedruckter Schaltungen oder Leiterplatten mittels Photoresistschichten notwendig, sich nach der bildmäßigen Belichtung und vor der Entfernung der unbelichteten Bereiche der Photoresistschichten zu vergewissern, ob das Negativ richtig aufgelegt war. Ferner ermöglicht die Farbänderung bei der bildmäßigen Belichtung von Schichten aus den photopolymerisierbaren Aufzeichnungsmaterialien eine Kontrolle des erhaltenen Bildes nach der Entwicklung der belichteten Schicht, so daß hierdurch beispielsweise etwaige Ablösungen der Bildteile der Schicht bei der Entwicklung leicht und zuverlässig festgestellt werden können. Um eine möglichst gute visuelle Beurteilung dieser belichteten Schichten vornehmen zu können, soll das farbbildende System bei der Belichtung einen möglichst starken Farbkontrast in den Aufzeichnungsmaterialien bewirken, wobei angestrebt wird, daß durch die Farbbildung möglichst dunkle Bilder bei Betrachtung im Gelblicht erhalten werden. Ferner müssen die farbbildenden Systeme lagerstabil sein, damit in den photopolymerisierbaren Aufzeichnungsmaterialien in der Zeit zwischen Herstellung und Anwendung keine unerwünschte Farbvertiefung und Verschlechterung des Kontrasts nach dem Belichten auftritt. Eine häufige störende Folge einer unerwünschten Farbvertiefung ist auch ein damit verbundener Rückgang der Lichtempfindlichkeit.

Die farbbildenden Systeme bestehen im allgemeinen aus einer farblosen oder schwach gefärbten Farbstoff-Vorstufe (Farbbildner) und einem Aktivator, der bei Bestrahlung mit aktinischem Licht die Farbstoff-Vorstufe in die farbige Verbindung überführt. Als Farbbildner kommen insbesondere Leukofarbstoffe oder die schwach gefärbten freien Basen oder Lactonformen von Farbstoffen in Betracht. Als Aktivatoren für die Farbbildner werden üblicherweise Photooxidationsmittel eingesetzt, wobei hierfür insbesondere organische Halogenverbindungen beschrieben werden, die bei Bestrahlung mit aktinischem Licht Halogenradikale abspalten. Verwiesen sei in diesem Zusammenhang z.B. auf die DE-A-23 06 353, DE-A-27 18 200, EP-B-2805, EP-B-5379 sowie WO-A-80/01846. Es ist auch schon vorgeschlagen worden, als Photooxidationsmittel Hexaarylbisimidazolyle zu verwenden (vgl. DE-A-19 24 317 sowie EP-B-19219). Die bekannten photopolymerisierbaren Aufzeichnungsmaterialien enthalten darüber hinaus in aller Regel zur Empfindlichkeitssteigerung und Verbesserung der Photoreaktion auch noch einen Sensibilisator, z.B. ein tertiäres Amin einer aromatischen Carbonylverbindung, wie z.B. Michlers Keton.

Die in den bekannten Bilderzeugungsmaterialien eingesetzten farbbildenen Systeme zeigen bei der bildmäßigen Belichtung dieser Materialien mit aktinischem Licht häufig nur einen schwachen Farbumschlag und einen nicht zufriedenstellenden Kontrast zwischen belichteten und unbelichteten Bereichen.

Ein vielfach anzutreffendes Problem ist auch in der mangelnden Lagerstabilität der bisher für die Bilderzeugung verwendeten farbbildenden Systeme zu sehen. So ist in vielen Fällen bereits bei der Lagerung des unbelichteten Materials im Dunkeln eine Farbvertiefung zu beobachten, die eine Verschlechterung des Kontrasts nach Belichtung und eine spürbare Verlängerung der erfoderlichen Belichtungszeit (um bis zu 100 %) bewirkt. Die Verarbeitung von photopolymerisierbaren Aufzeichnungsmaterialien, die ein nicht lagerstabiles farbbildendes System enthalten, wird durch die beschriebene Farbvertiefung erheblich beeinträchtigt, weil z.B. die Kontrolle in der Leiterplattenfabrikation erschwert wird oder die erforderliche Belichtungszeit bei jedem Chargenwechsel neu ermittelt werden muß. In verschärfter Weise tritt das Problem der Farbvertiefung bei wäßrigalkalisch entwickelbaren Schichten auf, weil das saure Milieu die

Farbvertiefung noch beschleunigt. Aus den genannten Gründen besteht daher nach wie vor ein Bedarf an verbesserten Bilderzeugungsmaterialien.

Ziel der vorliegenden Erfindung ist es, ein Bilderzeugungsmaterial herzustellen, das die genannten Nachteile nicht aufweist, d.h. insbesondere ein Bilderzeugungsmaterial, das sich durch hohe Lagerstabilität über längere Zeit auch bei erhöhter Temperatur und Luftfeuchtigkeit auszeichnet.

Zur Lösung des Problems der zu geringen Lagerstabilität von farbbildenden Systemen wurde bereits vorgeschlagen, Antioxidationsmittel (z.B. US-A-4 066 459) oder Oxime (z.B. DE-A-29 41 846) als Stabilisatoren zuzusetzen oder spezielle Leukoverbindungen zu verwenden, wie z.B. in DE-A-34 33 026, in der Auskopiermittel beschrieben werden, die Leukofarbstoff und Photooxidationsmittel enthalten, wobei als Leukofarbstoff beispielsweise Bis(dimethylaminophenyl)-[(N-ethyl)carbazolyl]methan eingesetzt wird.

Überraschenderweise wurde nun gefunden, daß sich ein besonders lagerstabiles Bilderzeugungsmaterial dadurch erhalten läßt, daß man ein farbbildendes System (b), bestehend aus (b1) einem Photooxidationsmittel, (b3) ggf. einem Sensibilisator und (b2) einer Leukoverbindung der allgemeinen Formel (I) einsetzt.

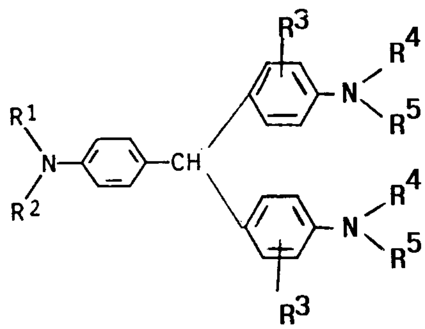

(I)

wobei $R^1$ bis $R^5$ die im folgenden angegebene Bedeutung haben.

Gegenstand der vorliegenden Erfindung ist ein lichtempfindliches Aufzeichnungsmaterial, im wesentlichen bestehend aus einem Gemisch aus

(a) einem oder mehreren filmbildenden polymeren Bindemitteln,
(b) einem Farbbildnersystem,
(c) gegebenenfalls einer oder mehreren polymerisierbaren mindestens einfach ethylenisch ungesättigten monomeren organischen Verbindungen,
(d) gegebenenfalls einem durch Bestrahlung aktivierbaren Photoinitiator oder Photoinitiatorsystem und
(e) gegebenenfalls üblichen Zusatz- und Hilfsstoffen,

das dadurch gekennzeichnet ist, daß das Aufzeichnungsmaterial als Farbbildnersystem (b) ein Gemisch aus

(b1) einem Photooxidationsmittel,
(b2) einer Leukoverbindung der allgemeinen Formel (I)

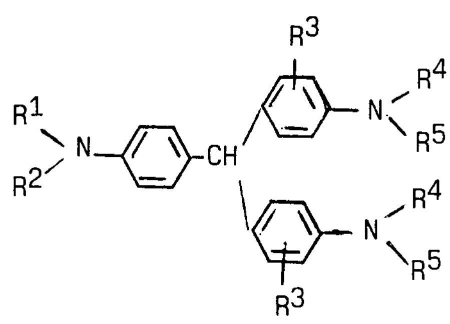

(I)

worin

$R^1$ = Alkyl mit 1 bis 8 Kohlenstoffatomen, Arylalkyl mit 1 bis 6 Kohlenstoffatomen in der Alkylgruppe,
durch OH, Halogen, Nitril, -O-CO-Alkyl mit 1 bis 6 Kohlenstoffatomen in der Alkylgruppe,
-CO-O-Alkyl mit 1 bis 6 Kohlenstoffatomen in der Alkylgruppe substituiertes Alkyl mit 1 bis 12 Kohlenstoffatomen oder Oxaalkyl mit 3 bis 12 Kohlenstoff- und 1 bis 5 Sauerstoffatomen;

$R^2$ = Phenyl, durch Alkyl mit 1 bis 8 Kohlenstoffatomen, Alkoxy mit 1 bis 8 Kohlenstoffatomen, Nitril, Trifluormethyl oder Halogen ein- oder mehrfach substituiertes Phenyl,

$R^3$ = Wasserstoff, Halogen, Alkyl mit 1 bis 8 Kohlenstoffatomen oder Alkoxy mit 1 bis 8 Kohlenstoffatomen,

$R^4$ und $R^5$ untereinander gleich oder verschieden sind und für Alkyl mit 1 bis 8 Kohlenstoffatomen, Arylalkyl mit 1 bis 6 Kohlenstoffatomen in der Alkylgruppe, wobei der Arylrest durch Halogen, Alkyl mit 1 bis 6 Kohlenstoffatomen oder Alkoxy mit 1 bis 6 Kohlenstoffatomen ein- oder mehrfach substituiert sein kann, durch OH, Halogen, Nitril, -O-CO-Alkyl mit 1 bis 6 Kohlenstoffatomen im Alkylrest, -CO-O-Alkyl mit 1 bis 6 Kohlenstoffatomen im Alkylrest substituiertes, 1 bis 6 Kohlenstoffatome enthaltendes Alkyl oder Oxaalkyl mit 3 bis 12 Kohlenstoffatomen und 1 bis 5 Sauerstoffatomen stehen, oder $R^4$ zusammen mit $R^5$ ein gesättigtes oder ungesättigtes heterocyclisches Ringsystem bilden,

sowie gegebenenfalls

(b3) einem Sensibilisator enthält.

Im erfindungsgemäßen Aufzeichnungsmaterial enthält das Farbbildnersystem (b) als Photooxidationsmittel (b1) vorzugsweise ein Hexaarylbisimidazolyl der Formel (II) oder einer strukturisomeren Form davon

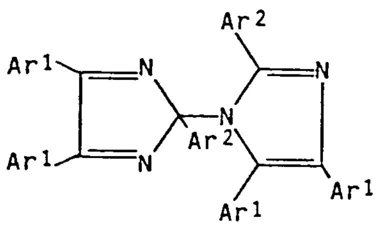

(II)

worin $Ar^1$ für einen substituierten oder unsubstituierten Phenylrest und $Ar^2$ für einen in der 2- oder 2'-Position durch Halogen oder einen Alkylrest substituierten Phenylrest stehen, oder ein heteroaromatisches salzartiges System mit mindestens einer Gruppierung der Formel (III)

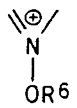

(III)

worin $R^6$ für einen Alkyl-, Cycloalkyl- oder Arylrest oder einen substituierten Alkyl-, Cycloalkyl- oder Arylrest steht.

Im erfindungsgemäßen Aufzeichnungsmaterial ist die Leukoverbindung (b2) im allgemeinen in einer Menge von 0,01 bis 10, vorzugsweise 0,1 bis 2 Gew.%, bezogen auf die Gesamtmenge des lichtempfindlichen Aufzeichnungsmaterials enthalten.

Gegenstand der Erfindung ist außerdem ein Verfahren zur Herstellung von Hochdruck- oder Tiefdruckplatten, wobei man erfindungsgemäßes lichtempfindliches Aufzeichnungsmaterial einsetzt.

Ebenso ist ein Verfahren zur Herstellung von Flachdruckplatten oder Photoresistfilmen, wobei man erfindungsgemäßes lichtempfindliches Aufzeichnungsmaterial einsetzt, Gegenstand der Erfindung.

Gegenstand der vorliegenden Erfindung ist auch die neue Leukoverbindung der Formel

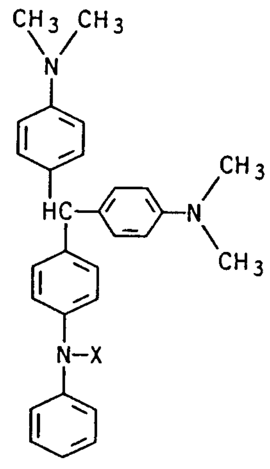

worin X für $C_2H_5$ oder

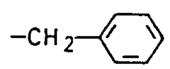

steht,
sowie lichtempfindliches Aufzeichnungsmaterial, das diese neue Leukoverbindung als Komponente (b2) enthält.

Die erfindungsgemäßen Aufzeichnungsmaterialien und die damit hergestellten Druckplatten und Resists zeichnen sich besonders durch einen hervorragenden Farbkontrast und eine hohe Lagerstabilität aus.

Zu den Aufbaukomponenten der erfindungsgemäßen lichtempfindlichen, silberhalogenidfreien Aufzeichnungsmaterialien ist im einzelnen folgendes auszuführen.

(a) Als filmbildende polymere Bindemittel (a) kommen beispielsweise in Frage: lineare Polyamide und besonders alkohollösliche Copolyamide, wie sie in der FR-PS 1 520 856 beschrieben sind; Cellulosederivate, insbesondere wäßrig-alkalisch auswaschbare Cellulosederivate, Vinylalkohol-Polymere und Polymere und Copolymere von Vinylestern aliphatischer Monocarbonsäuren mit 1 bis 4 C-Atomen, wie von Vinylacetat, mit unterschiedlichem Verseifungsgrad, Homo- und Copolymerisate des Vinylpyrrolidons, des Vinylchlorids oder des Styrols, Polyurethane, Polyetherurethane, Polyesterurethane, Polyesterharze, Dien-Polymere und -Copolymere, wie Blockcopolymerisate aus Butadien und/oder Isopren und Styrol oder α-Methylstyrol, sowie, insbesondere für die Herstellung von Photoresistschichten und Flachdruckplatten, auch die Acrylsäurealkylester- und Methacrylsäurealkylester-Polymerisate und -Copolymerisate. Beispiele für geeignete und bevorzugte polymere Bindemittel sind u.a. Polymethacrylat, Polymethylmethacrylat, Alkyl(meth)acrylat-Copolymerisate, die Amino-Gruppen enthaltende Comonomere, wie z.B. Dimethylaminoethylmethacrylat, einpolymerisiert enthalten, Copolymerisate von Alkyl(meth)acrylaten und (Meth)acrylsäure, die gegebenenfalls noch weitere Comonomere, wie z.B. N-Vinyllactame, Hydroxyalkyl(meth)acrylate oder Styrol, einpolymerisiert enthalten, Copolymerisate aus Styrol und Maleinsäureanhydrid und/oder Maleinsäurehalbester oder auch Copolymerisate von Styrol, Maleinsäureanhydrid und (Meth)acrylsäure.

In den Fällen, in denen die erfindungsgemäßen farbbildenden Systeme in photopolymerisierbaren Aufzeichnungsschichten eingesetzt werden, werden die polymeren Bindemittel so gewählt, daß sie in den Entwicklerlösungsmitteln für die photopolymerisierbaren Aufzeichnungsschichten löslich oder zumindest dispergierbar sind, um ein Auswaschen der unbelichteten und unvernetzten Anteile einer Schicht aus diesen Materialien nach einer bildmäßigen Belichtung mit aktinischem Licht zu ermöglichen.

Komponente (a) ist im erfindungsgemäßen Aufzeichnungsmaterial im allgemeinen in einer Menge von 10 bis 99, vorzugsweise 20 bis 80 Gew.%, bezogen auf das Gesamtgewicht der lichtempfindlichen Aufzeichnungsschicht enthalten.

(b) Das Farbbildnersystem (b) enthält ein Gemisch aus

(b1) einem Photooxidationsmittel,

(b2) einer Leukoverbindung der oben genannten Formel (I) sowie gegebenenfalls

(b3) einem Sensibilisator.

(b1) Als im farbbildenden System der erfindungsgemäßen Aufzeichnungs-bzw. Bilderzeugungsmaterialien enthaltene Photooxidationsmittel (b1) kommen insbesondere Hexaarylbisimidazolyle der Formel (II) oder einer strukturisomeren Form davon

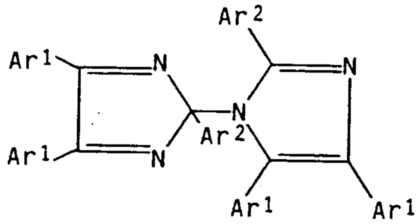

(II)

worin $Ar^1$ und $Ar^2$ die unten angegebene Bedeutung haben, oder heterocyclische Systeme mit mindestens einer Gruppierung der Formel (III)

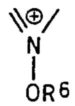

(III)

in Betracht.

Bei den Photooxidationsmitteln (b1) gemäß Formel (II) handelt es sich um 2,4,5-Triarylimidazolyl-Dimere, bei denen zwei Imidazolreste durch eine kovalente Bindung verknüpft sind, wobei $Ar^1$ für einen substituierten oder unsubstituierten Phenylrest, vorzugsweise für einen unsubstituierten oder in 4-Position durch $C_1$-$C_6$-Alkyl oder $C_1$-$C_6$-Alkoxy substituierten Phenylrest und $Ar^2$ für einen in der 2- oder 2'-Position durch Halogen wie F, Cl, Br oder einen Alkylrest substituierten Phenylrest steht. Aus dem 2,4,5-Triarylimidazol-Dimeren entstehen durch Lichteinwirkung die eigentlichen Photooxidationsmittel, die Triarylimidazolyl-Radikale.

Besonders bevorzugt sind das 2,2'-Bis(o-chlorphenyl)-4,4',5,5'-tetraphenylbisimidazol und das 2,2'-Bis(-o-chlorphenyl)-4,4',5,5'-tetra(p-methoxyphenyl)bisimidazol.

Diese Hexaarylbisimidazole sind an sich bekannt oder lassen sich leicht nach Methoden darstellen, wie sie beispielsweise in J. Org. Chem., 36 (1971), 2262 beschrieben sind.

Zu den Photooxidationsmitteln (b1), die im heteroaromatischen Ring eine Gruppierung der oben angegebenen allgemeinen Formel (III) eingebaut enthalten, gehören insbesondere die Pyridinium-, Pyrazinium- und Pyrimidinium-Salze, ferner die kernsubstituierten Derivate dieser Salze, die einen oder mehrere Substituenten im heteroaromatischen Ring enthalten, sowie auch annellierte Derivate dieser Salze, wie z.B. benzannellierte Pyridinium-Salze der in Rede stehenden Art, wie etwa die entsprechenden, gegebenenfalls kernsubstituierten Chinolinium-, Isochinolinium- oder Phenanthridinium-Salze. In der allgemeinen Formel (III) kann $R^6$ für einen gegebenenfalls substituierten Alkyl- oder Arylrest, sowie für einen Cycloalkylrest stehen. Weitere geeignete Photoxidationsmittel sind in der deutschen Patentanmeldung DE-A-37 17 037 im einzelnen angeführt. Bevorzugt für den Rest $R^6$ in der Gruppierung der allgemeinen Formel (III) sind Alkyl- und Arylreste, insbesondere Alkylgruppen mit 1 bis 6 C-Atomen. Zu den bevorzugten Kernsubstituenten für diese Salze gehören insbesondere die, gegebenenfalls substituierten, Alkylreste. Als Anionen für diese Salze sind u.a. bevorzugt Benzolsulfonat-, Tosylat-, Alkylsulfonat-, Trifluormethansulfonat- oder Tetrafluoroborat-Anionen. Als besonders vorteilhaft für den erfindungsgemäßen Einsatz haben sich dabei die N-Alkoxy- und N-Aryloxy-pyridiniumsalze, die N-Alkoxy- und N-Aryloxy-picoliniumsalze sowie die N-Alkoxy- und N-Aryloxy-lutidiniumsalze erwiesen. Auch Gemische der unter (b1) genannten Photooxidationsmittel sind einsetzbar.

Die als Photooxidationsmittel (b1) einzusetzenden Salze der vorstehend beschriebenen Art lassen sich nach üblichen und gängigen literaturbekannten Verfahren oder in Analogie zu diesen herstellen. Verwiesen sei in diesem Zusammenhang z.B. auf R.A. Abramovitch und E.M. Smith in "Pyridine and its Derivatives", Vol. 14, Supplement, Part 2, Seite 1ff, J. Wiley, New York (1974). Die Photooxidationsmittel (b1) sind in den erfindungsgemäßen lichtempfindlichen Aufzeichnungsmaterialien im allgemeinen in Mengen von 0,05 bis 10, vorzugsweise 0,1 bis 5 Gew.%, bezogen auf das Gesamtgewicht der

lichtempfindlichen Aufzeichnungsschicht enthalten.

(b2) Als Leukoverbindungen kommen erfindungsgemäß die der allgemeinen Formel (I)

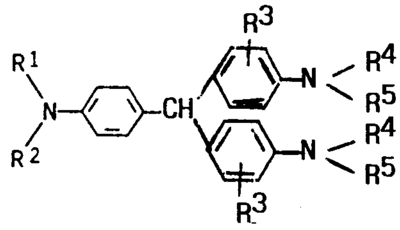

(I)

in Betracht,

worin der Rest $R^1$ für $C_1$-$C_8$-Alkyl, wie z.B. Methyl, Ethyl, n-Propyl, i-Propyl, n-Butyl, i-Butyl, tert.-Butyl, Amyl, n-Hexyl, Heptyl, n-Octyl, i-Octyl, 2-Ethylhexyl, Aryl-$C_1$-$C_6$-alkyl, beispielsweise Benzyl, 2-Phenylethyl, Aryl-$C_1$-$C_6$-alkyl, worin der Arylrest durch Halogen, $C_1$-$C_6$-Alkyl, beispielsweise Methyl, Ethyl, n-Propyl, i-Propyl, n-Butyl, i-Butyl, t.Butyl, n-Hexyl,

$C_1$-$C_6$-Alkoxy, beispielsweise Methoxy, Ethoxy, n-Propoxy, i-Propoxy, n-Butoxy, t-Butoxy, n-Hexoxy

ein- oder mehrfach substituiert sein kann, wie z.B. p-Methoxybenzyl, 2,4-Dichlorbenzyl, p-Methoxyphenyl, für gegebenenfalls durch OH, Halogen, CN, -O-CO-$C_1$- bis $C_6$-Alkyl, wie z.B. Acetoxy, Propionyloxy oder -CO-O-$C_1$- bis $C_6$-alkyl-substituiertes $C_1$-$C_{12}$-Alkyl oder Oxaalkyl mit 3 bis 12 Kohlenstoffatomen und 1 bis 5 Sauerstoffatomen, wie z.B. Ethoxyethyl, der Rest $R^2$ für Phenyl oder durch $C_1$-$C_8$-Alkyl, wie z.B. Methyl, Ethyl, n-Propyl, n-Butyl, i-Butyl, t.Butyl, n-Hexyl, Heptyl, Octyl, 2-Ethylhexyl, $C_1$-$C_8$-Alkoxy, wie z.B. Methoxy, Ethoxy, n-Propoxy, i-Propoxy, n-Butoxy, t-Butoxy, n-Hexoxy, Nitril, Trifluormethyl und/oder Halogen ein- oder mehrfach substituiertes Phenyl,

der Rest $R^3$ für Wasserstoff, Halogen $C_1$-$C_8$-Alkyl, wie z.B. Methyl, Ethyl, n-Propyl, i-Propyl, n-Butyl, i-Butyl, t-Butyl, n-Hexyl, Heptyl, Octyl, 2-Ethylhexyl oder $C_1$-$C_8$-Alkoxy, wie z.B. Methoxy, Ethoxy, n-Propoxy, i-Propoxy, n-Butoxy, t-Butoxy, n-Hexoxy stehen kann und

die Reste $R^4$ und $R^5$ untereinander gleich oder verschieden sein können und für $C_1$-$C_8$-Alkyl, wie z.B. Methyl, Ethyl, n-Propyl, i-Propyl, n-Butyl, i-Butyl, t-Butyl, n-Hexyl, Heptyl, Octyl, 2-Ethylhexyl, Aryl-$C_1$- bis $C_6$-alkyl, wie z.B. Benzyl, Phenylethyl, wobei der Arylrest durch Halogen, wie z.B. F, Cl, Br, J, $C_1$-$C_6$-Alkyl, wie z.B. Methyl, Ethyl, n-Propyl, i-Propyl, n-Butyl, i-Butyl, t-Butyl, n-Hexyl oder $C_1$-$C_6$-Alkoxy, wie z.B. Methoxy, Ethoxy, n-Propoxy, i-Propoxy, n-Butoxy, t-Butoxy, n-Hexoxy, ein- oder mehrfach substituiert sein kann, für gegebenenfalls durch OH, Halogen, CN, -O-CO-$C_1$- bis $C_6$-Alkyl, wie z.B. Acetoxy, Propionyloxy, oder Oxaalkyl mit 3 bis 12 Kohlenstoffatomen und 1 bis 5 Sauerstoffatomen wie z.B. Ethoxyethyl stehen oder $R^4$ und $R^5$ zusammen ein gesättigtes oder ungesättigtes heterocyclisches Ringsystem bilden, wie z.B. einen Carbazol- oder Morpholinring.

Als Beispiele für geeignete und ganz besonders bevorzugte Leukoverbindungen seien genannt:

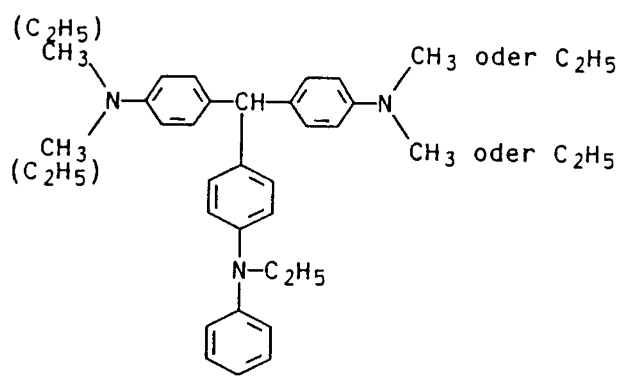

**(IV)**

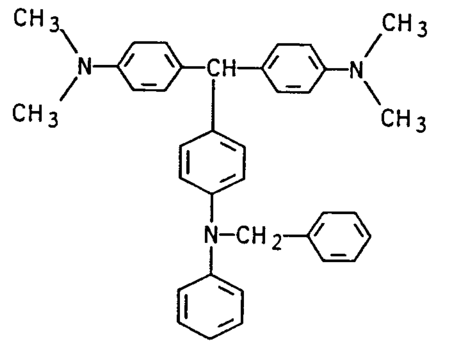

(V)

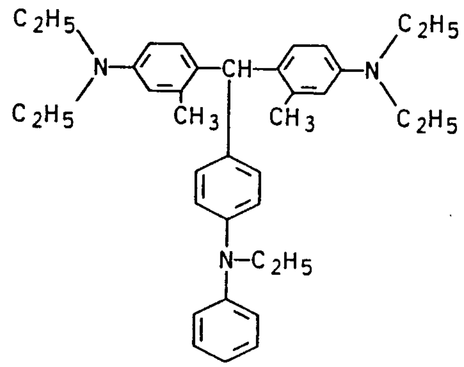

(VI)

Der erfindungsgemäße Einsatz der Leukoverbindungen der vorstehend beschriebenen Art in einem Farbbildnersystem hat eine deutliche Verbesserung der Lagerstabilität im Dunkeln auch bei erhöhter Temperatur und Luftfeuchtigkeit zur Folge. Durch den Einsatz der erfindungsgemäßen Leukoverbindungen wird sowohl die Farbvertiefung als auch der Rückgang der Lichtempfindlichkeit vermieden.

Die erfindungsgemäß als Leukoverbindungen eingesetzten Substanzen sind teilweise bekannt oder können in Anlehnung an in der Literatur beschriebene Verfahren hergestellt werden, beispielsweise durch Kondensation eines aromatischen Aldehyds mit einem geeigneten Amin im sauren Medium gemäß der allgemeinen Gleichung

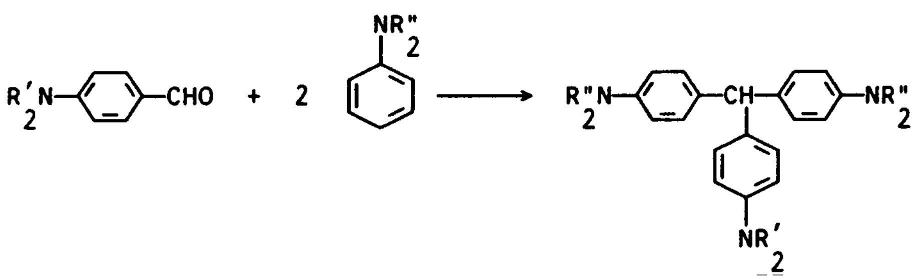

wie z.B. in J. Assoc. Off. Agric. Chem. 38 (1955), 977 beschrieben.

Die Leukoverbindungen werden im allgemeinen in Mengen von 0,01 bis 10, vorzugsweise von 0,1 bis 2 Gew.%, bezogen auf die Gesamtmenge des erfindungsgemäßen lichtempfindlichen Aufzeichnungsmaterials, eingesetzt.

Zusätzlich zu einem Photooxidationsmittel und einer Leukoverbindung kann das erfindungsgemäße Farbbildnersystem eine als Sensibilisator wirkende Verbindung (b3) enthalten. Als im farbbildenden System enthaltene Sensibilisatoren (b3) im weiteren Sinne kommen Verbindungen in Betracht, die bei Bestrahlung des Bilderzeugungsmaterials mit aktinischem Licht das aktinische Licht zu absorbieren und die Anregungsenergie der Elektronen auf das Photooxidationsmittel zu übertragen vermögen und dadurch die photochemischen Reaktionen in den Bilderzeugungsmaterialien bei deren Bestrahlung mit aktinischem Licht aktivieren.

Als Beispiele für Sensibilisatoren seien p-Aminophenylketone, Thioxanthone, die in der DE-A-37 17 038 beschriebenen Triazolderivate, die in der DE-A-37 17 036 beschriebenen 4-Phenylpyridine, die in der DE-A-37 170 34 beschriebenen Chinazolon-4-Verbindungen sowie die in der DE-A-37 17 033 beschriebenen Imidazol-Derivate genannt.

Diese Sensibilisatoren (b3) können im erfindungsgemäßen Aufzeichnungsmaterial in Mengen von bis zu 5, vorzugsweise 0,01 bis 2 Gew.%, bezogen auf das Gesamtgewicht der lichtempfindlichen Aufzeichnungsschicht eingesetzt werden.

Neben dem polymeren Bindemittel und dem farbbildenden System können die erfindungsgemäßen Aufzeichnungs- bzw. Bilderzeugungsmaterialien eine oder mehrere photopolymerisierbare, olefinisch ungesättigte organische Verbindungen (c) enthalten.

Die photopolymerisierbaren, olefinisch ungesättigten organischen Verbindungen (c) enthalten vorzugsweise vinylische Doppelbindungen und insbesondere Vinyl-Gruppen, die durch Konjugation und/oder Nachbarschaftsstellung zu O- oder N-Atomen aktiviert sind. Hierzu gehören insbesondere die Vinyl-Gruppen in Nachbarschaft zu Ester- oder Amidgruppen, wie z.B. die Acryloyl- und Methacryloyl-Gruppierungen. Die photopolymerisierbaren, olefinisch ungesättigten organischen Verbindungen können sowohl mono- als auch polyfunktionell sein, d.h. sie können eine oder auch mehrere der photopolymerisierbaren olefinischen Doppelbindungen besitzen. Üblicherweise sind in den photopolymerisierbaren Aufzeichungsmaterialien bi- oder mehrfunktionelle olefinisch ungesättigte, photopolymerisierbare Verbindungen allein oder Mischungen hiervon mit monofunktionellen olefinisch ungesättigten photopolymerisierbaren organischen Verbindungen enthalten. Die photopolymerisierbaren olefinisch ungesättigten Monomeren haben im allgemeinen ein Molekulargewicht von bis zu etwa 1 000. Art und Menge der verwendeten photopolymerisierbaren, olefinisch ungesättigten organischen Verbindungen richten sich weitgehend nach dem Anwendungszweck der photopolymerisierbaren Aufzeichnungsmaterialien sowie nach der Art der weiteren mitverwendeten Bestandteile.

Als Vertreter für die photopolymerisierbaren Monomeren seien insbesondere die Derivate der (Meth)-acrylsäure und ganz besonders die (Meth)acrylsäureester genannt. Beispiele hierfür sind die Di- und Tri-(meth)acrylate von Ethylenglykol, Diethylenglykol, Triethylenglykol oder Polyethylenglykolen mit einem Molekulargewicht bis etwa 500, von 1,2-Propandiol, 1,3-Propandiol, Polypropylenglykolen mit einem Molekulargewicht bis etwa 500, von 1,4-Butandiol, 1,6-Butandiol, 1,1,1-Trimethylolpropan, 2,2-Dimethylpropandiol, Glycerin, oder Pentaerythrit; Pentaerythrittetra-(meth)acrylat, Glukosetri- oder tetra-(meth)acrylat; ferner die Monoacrylate und Monomethacrylate der genannten Diole und Polyole, wie z.B. Ethylenglykol-, Di-, Tri- oder Tetraethylenglykol-mono-(meth)acrylat, Propandiolmono(meth)acrylat und Butandiol-mono-(meth)-acrylat; sowie die (Meth)-acrylate von Monoalkanolen, insbesondere von solchen mit 1 bis 20 C-Atomen. Neben den bevorzugten Acrylaten und Methacrylaten der vorstehend genannten Art seien als photopolymerisierbare Monomere auch die Allyl-Verbindungen und andere Vinyl-Verbindungen genannt, wie z.B. N-Vinylpyrrolidon, N-Vinylcarbazol, N-Vinylcaprolactam, Vinylacetat, Vinylpropionat, (Meth)acrylamid, N-Methylol-(meth)acrylamid, der Bisether des Ethylenglykols und N-Methylol-(meth)acrylamids, Vinylcarbamate, Bisacrylamidoessigsäure, Glyoxalbisamid u.a.

Sehr geeignete photopolymerisierbare, olefinisch ungesättigte organische Verbindungen für die erfindungsgemäßen, photopolymerisierbaren Aufzeichnungsmaterialien sind auch die monomeren Urethanacrylate bzw. -methacrylate mit zwei oder mehr Acryloyl- und/oder Methacryloyl-Gruppen. Solche monomeren Urethan-(meth)acrylate können beispielsweise erhalten werden durch die Umsetzung von aliphatischen Di- oder Polyolen mit organischen Diisocyanaten in einem Äquivalentverhältnis OH:NCO von etwa 1:2 und anschließende Umsetzung der freien Isocyanatgruppen des erhaltenen Reaktionsproduktes mit geeigneten Acryloyl- und/oder Methacryloyl-Verbindungen, beispielsweise Hydroxyalkyl-(meth)acrylaten. Als aliphatische Di- und/oder Polyole kommen u.a. die vorstehend im Zusammenhang mit den Di- und Tri-(meth)-acrylaten genannten Di- und Polyhydroxy-Verbindungen in Betracht; als Beispiele für organische Diisocyanate seien Hexamethylendiisocyanat, Toluylendiisocyanat, Isophorondiisocyanat und ähnliche genannt: Hydroxyalkyl(meth)acrylate sind beispielsweise Hydroxylethyl(meth)acrylat, Propandiol-mono-(meth)acrylat oder Butandiol-mono-(meth)acrylat. Ebenso geeignet und vorteilhaft sind Monomere mit zwei oder mehr Acryloyl-und/oder Methacryloyl-Gruppen, wie sie beispielsweise erhalten werden können durch Umsetzung von Di- oder Polyglycidylverbindungen mit Acrylsäure und/oder Methacrylsäure bzw. durch Umsetzung von Glycidyl(meth)acrylat mit Di- oder Polyolen, insbesondere aliphatischen Di- oder Polyolen, wie sie beispielsweise vorstehend im Zusammenhang mit den Di- und Tri(meth)acrylaten genannt sind. Als Di- und Polyglycidylverbindungen kommen hier insbesondere die Di- und Polyglycidylether mehrwertiger aliphatischer Alkohole oder mehrwertiger Phenole, beispielsweise des Bisphenols A oder der Substitutionsprodukte von Bisphenol A in Betracht. Beispielhaft für solche Acryloyl- und/oder Methacryloyl-Gruppen enthaltenden Monomeren seien die Umsetzungsprodukte des Bisphenol A-bisglycidylethers mit Acryl- und/oder Methacrylsäure im molaren Verhältnis von etwa 1:2 sowie das 1,6-Hexandiol-bis-glycidylether-methacrylat genannt.

Die photopolymerisierbaren, olefinisch ungesättigten organischen Verbindungen (c), die üblicherweise einen Siedepunkt von über 100 °C bei Atmosphärendruck aufweisen, sind dabei - für den Fachmann

selbstverständlich -so zu wählen, daß sie mit den übrigen Bestandteilen der photopolymerisierbare Aufzeichnungsmaterialien, insbesondere den mitverwendeten polymeren Bindemitteln, verträglich sind.

Falls die erfindungsgemäßen Aufzeichnungs- bzw. Bilderzeugungsmaterialien eine oder mehrere photopolymerisierbare, olefinisch ungesättigte organische Verbindungen enthalten, kann das im farbbildenden System enthaltene Photooxidationsmittel gleichzeitig als Photopolymerisationsinitiator wirken. Die erfindungsgemäßen Bilderzeugungsmaterialien können aber auch zusätzlich einen Photoinitiator oder ein Photoinititatorsystem (d) enthalten, das bei Bestrahlung mit aktinischem Licht Radikale bildet und eine Polymerisation der photopolymerisierbaren, olefinisch ungesättigten organischen Verbindungen bewirkt.

Als besonders vorteilhaft haben sich hier die als Photoinitiatoren bekannten aromatischen Carbonylverbindungen erwiesen, insbesondere aromatische Ketone, die eine Struktureinheit der allgemeinen Formel (VII)

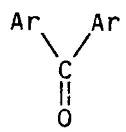

(VII)

aufweisen, worin Ar für einen gegebenenfalls substituierten Arylrest, insbesondere einen gegebenenfalls substituierten Phenylrest, steht. Die beiden Reste Ar in der Struktureinheit der allgemeinen Formel (VII) können dabei gleich oder verschieden sein sowie gegebenenfalls auch, beispielsweise über eine -CH-Gruppe oder ein -S-Atom, miteinander verknüpft sein. Bevorzugt werden die Photopolymerisationsinitiatoren so ausgewählt, daß sie keine starke Absorption ($\epsilon$ <5000) in dem Wellenlängenbereich des aktinischem Lichts haben, in dem die in den erfindungsgemäßen photopolymerisierbaren Aufzeichnungsmaterialien enthaltenen Sensibilisatoren ihre Absorptionsbande(n) haben. Als Beispiele für bevorzugte Photopolymerisationsinitiatoren seien genannt: Benzophenon, substituierte Benzophenone, wie 4,4'-Dichlorbenzophenon, Benzoinether, Benzildialkylketal, mehrkernige unsubstituierte Chinone, wie Anthrachinon, Benzanthrachinon, 2-Ethylanthrachinon oder tert.-Butylanthrachinon, Thioxanthon und seine Derivate, wie z.B. 2-Methylthioxanthon und 2-Chlorthioxanthon.

Derartige Photoinitiatoren bzw. Photoinitiatorsysteme (d) können in Mengen von 0 bis 5 Gew.%, bezogen auf Gesamtgewicht des lichtempfindlichen Aufzeichnungsschicht vorhanden sein.

Neben den genannten Bestandteilen (a) bis (d) können die erfindungsgemäßen photopolymerisierbaren Aufzeichnungsmaterialien noch weitere, übliche, die verarbeitungs- und/oder anwendungstechnischen Eigenschaften der Aufzeichungsmaterialien verbessernde und/oder modifizierende Zusatz- und/oder Hilfsstoffe (e) enthalten. Hierzu gehören u.a. Inhibitoren zur Verhinderung der thermischen Polymerisation, anorganische oder organische Pigmente oder Farbstoffe, die sowohl als Kontrastmittel als auch schichtverfestigend wirken können, niedermolekulare Haftvermittler, Verlaufshilfsmittel, Mattierungs- oder Gleitmittel, Weichmacher und dgl.

Die Bestandteile der erfindungsgemäßen photopolymerisierbaren Aufzeichnungsmaterialien werden in den für sie üblichen und an sich bekannten Mengen und Mengenverhältnissen eingesetzt und liegen in den Aufzeichnungsmaterialien in homogener Mischung vor. Zur Herstellung der photopolymerisierbaren Aufzeichnungsmaterialien werden die Bestandteile nach den an sich bekannten Verfahren homogen miteinander vermischt, beispielsweise in Lösung in einem geeigneten Lösungsmittel oder Lösungsmittelgemisch oder in einer Mischvorrichtung, wie einem Kneter, Extruder oder dgl. Vorzugsweise werden Art und Menge der einzelnen Bestandteile der erfindungsgemäßen photopolymerisierbaren Aufzeichnungsmaterialien so aufeinander abgestimmt, daß die resultierende Mischung - sofern die Mischung in Lösung hergestellt wurde, nach Entfernung des Lösungsmittels - fest ist.

Zum Auslösen der Photopolymerisation und der Farbbildung bzw. der Vertiefung der Farbintensität in den erfindungsgemäßen photopolymerisierbaren Aufzeichnungsmaterialien dient aktinisches Licht einer Wellenlänge von 300 bis 420 nm, insbesondere solches im Wellenlängenreich von 320 bis 400 nm. Als Strahlungsquellen sind u.a. Quecksilberhochdrucklampen, Quecksilbermitteldrucklampen, Quecksilberniederdrucklampen, superaktinische Leuchtstoffröhren, Xenon-Impulslampen, UV-Fluoreszenzröhren und dgl. geeignet.

Die erfindungsgemäßen Aufzeichungsmaterialien können in an sich bekannter Weise zu UV-härtbaren Überzügen, Photopolymerdruckplatten jeder Art, Reliefformen, Photoresists und dgl. verarbeitet werden.

Die erfindungsgemäßen farbbildenden Systeme können für sich allein als Bilderzeugungsmaterialien z.B. zur optischen Speicherung von Information, als Indikator für die Lichtmenge, der ein Artikel exponiert war oder als Aktinometer dienen. Zu diesem Zweck können sie für sich allein zu Filmen gegossen oder

nach bekannten Methoden auf Substrate aufgebracht werden. Zu diesem Zweck geeignete Substrate sind z.B. Papier, Zelluloseacetat, Zellulosenitrat, Polyester, Vinylpolymere und -copolymere, Polyethylen, Polyvinylacetat, Polymethylmethacrylat oder Polyvinylchlorid.

Besonders geeignet sind die erfindungsgemäßen farbbildenden Systeme für die Verwendung in photopolymerisierbaren Aufzeichnungsschichten, insbesondere in solchen Aufzeichnungsschichten, bei denen bei der Bestrahlung mit aktinischem Licht neben einer guten Photopolymerisation in den belichteten Bereichen auch eine möglichst große Änderung der Farbintensität und ein möglichst großer Farbkontrast gewünscht wird, wie beispielsweise in lichtempfindlichen Aufzeichungselementen mit einer auf einem Trägermaterial aufgebrachten dünnen Schicht aus den erfindungsgemäßen photopolymerisierbaren Aufzeichnungsmaterialien, insbesondere Trockenfilmresists für die trockene Schichtübertragung und Flachdruckplatten. Als Trägermaterial für diese lichtempfindlichen Aufzeichungselemente kommen die hierfür üblichen dimensionsstabilen, vorzugsweise biegsamen, Materialien, wie Kunststoffilme oder -folien und Metallbleche, in Betracht. Für Trockenfilmresists haben sich als Träger insbesondere Polyesterfolien, beispielsweise aus Polyethylenterephthalat oder Polybutylenterephthalat, bewährt. Für Flachdruckplatten finden als Trägermaterialien insbesondere die offsettypischen Aluminiumbleche Anwendung, deren Oberfläche in an sich bekannter Weise mechanisch, chemisch und/oder elektrochemisch aufgerauht und vorbehandelt ist. Die dünne Schicht aus den erfindungsgemäßen photopolymerisierbaren Aufzeichnungsmaterialien, die für die Trockenfilmresists üblicherweise im Bereich von etwa 10 bis 100 µm, insbesondere im Bereich von etwa 20 bis 70 µm liegt, wird auf die Trägermaterialien nach bekannten Auftragstechniken, beispielsweise durch Gießen aus Lösung oder spin coating aufgebracht.

Für die Herstellung von Flachdruckformen werden die mit den erfindungsgemäßen photopolymerisierbaren Aufzeichnungsmaterialien hergestellten Flachdruckplatten in üblicher Weise bildmäßig mit aktinischem Licht belichtet und durch Auswaschen mit einem geeigneten Entwicklerlösungsmittel entwickelt. Zur Herstellung von bildmäßig strukturierten Resistmustern wird das erfindungsgemäße photopolymerisierbare Aufzeichnungsmaterial schichtförmig auf das zu schützende, sowie gegebenenfalls dauerhaft zu modifizierende Substrat, entweder direkt, beispielsweise aus Lösung, oder durch Auflaminieren einer vorgefertigten Schicht nach dem Schichtübertragungsverfahren mittels eines Trockenfilmresist, aufgebracht. Als Substrat, dessen Art sich bekanntermaßen nach dem jeweiligen Anwendungszweck des herzustellenden Resistmusters richtet, kommen die in diesem Bereich üblichen und bekannten Materialien, wie z.B. Kupferbleche oder kupferkaschierte Basismaterialien, in Betracht. Zur Erzeugung des bildmäßig strukturierten Resistmusters wird die auf das Substrat aufgebrachte Photoresistschicht aus den erfindungsgemäßen photopolymerisierbaren Aufzeichnungsmaterialien bildmäßig mit aktinischem Licht belichtet und anschließend unter Entfernen der unbelichteten Schichtbereiche mit einem geeigneten Entwicklerlösungsmittel ausgewaschen. Für die bildmäßige Belichtung der erfindungsgemäßen photopolymerisierbaren Aufzeichnungsmaterialien kommt aktinisches Licht in dem vorstehend genannten Wellenlängenbereich in Betracht. Die Art des Entwicklerlösungsmittel richtet sich nach den für den Aufbau der erfindungsgemäßen photopolymerisierbaren Aufzeichnungsmaterialien verwendeten Bestandteile, insbesondere dem eingesetzten polymeren Bindemittel und/oder den photopolymerisierbaren, olefinisch ungesättigten organischen Verbindungen. Danach können sowohl organische Lösungsmittel oder Lösungsmittelgemische wie auch wäßrige Entwicklerlösungen zur Anwendung kommen.

Für die Herstellung von Hoch- oder Tiefdruckplatten wird in an sich bekannter Weise das erfindungsgemäße lichtempfindliche Aufzeichnungsmaterial in einer Dicke von 100 bis 2000 µm auf dimensionsstabile Träger, wie Metallbleche oder Folien, beispielsweise durch Extrusion und anschließendes Kalandrieren und Kaschieren auf den Träger, oder durch Aufgießen einer Lösung der Schichtbestandteile in einem geeigneten Lösungsmittel, aufgebracht. Der Träger kann vorher zweckmäßigerweise mit einer oder mehreren haftungsvermittelnden Schichten versehen worden sein.

Für die Herstellung von Hoch- oder Tiefdruckformen werden diese photopolymerisierbaren Druckplatten bildmäßig, beispielsweise durch ein geeignetes Negativ, mit aktinischem Licht belichtet, anschließend mit einem geeigneten Lösungsmittel die nicht belichteten Teile der photopolymerisierbaren Schicht abgewaschen und die so entstandenen Reliefplatten getrocknet und gegebenenfalls nachbelichtet.

Das farbbildende System in den erfindungsgemäßen Bilderzeugungsmaterialien besitzt eine hohe Stabilität. Die erfindungsgemäßen Bilderzeugungsmaterialien und photopolymerisierbaren Aufzeichnungsschichten weisen daher eine hohe Dunkellagerfähigkeit auf, ohne daß es hierzu des Zusatzes großer Mengen eines thermischen Inhibitors bedarf, wie er bei den Produkten nach dem Stand der Technik erforderlich ist. Bei der Belichtung mit aktinischem Licht zeigen die erfindungsgemäßen Bilderzeugungsmaterialien eine unerwartet große Zunahme der Farbintensität und einen stärkeren Farbkontrast zwischen belichteten und unbelichteten Bereichen, als er bei vergleichbaren bekannten Systemen erzielt wird.

Die Erfindung wird durch die nachfolgenden Beispiele näher erläutert. Die in den Beispielen und Vergleichsbeispielen genannten Teile und Prozente beziehen sich, sofern nicht anders angegeben, auf das Gewicht.

Beispiel 1 und Vergleichsbeispiel 1 bis 3

Eine Stammlösung zur Herstellung von wäßrig-alkalisch entwickelbaren Photoresistfilmen wird durch Mischen der folgenden Komponenten hergestellt:

| | |
|---|---|
| 1) 50%ige Lösung (in Essigester) eines Oligomeren ( = Umsetzungsprodukt aus Bisphenol A-diglycidylether (5 Teile), Adipinsäure (1,2 Teile), Acrylsäure (1 Teil) und Phthalsäureanhydrid (2,5 Teile) | 320,00 g |
| 2) 80 %ige Lösung (in Aceton) eines Copolymeren aus Methylmethacrylat (60 %), N-Vinylpyrrolidon (30 %) und Methacrylsäure (10 %) mit einem K-Wert (nach Fikentscher von 40 | 428,00 g |
| 3) Butandioldiacrylat | 44,00 g |
| 4) Trimethylolpropantriacrylat | 48,00 g |
| 5) Sicometpatentblau 80E131 (C.I. 42 051) | 0,20 g |
| 6) Benzophenon | 12,00 g |
| 7) Michlers Keton | 0,60 g |
| 8) N-Methoxypicolinium-benzolsulfonat | 10,00 g |

Die Lösung wurde in 4 gleiche Teile geteilt, zu denen jeweils 0,50 g (Bis(dimethylaminophenyl)[ethyl-(phenyl)aminophenyl]-methan (Beispiel 1, erfindungsgemäß), Kristallviolett-Leukobase (Vergeichsbeispiel 1), Malachitgrün-Leukobase (Vergleichsbeispiel 2) bzw. Bis(dimethylaminophenyl)-[(N-ethyl)carbazolyl]methan (Vergleichsbeispiel 3, vgl. DE-34 33 026) gegeben wurden. Die filtrierten Lösungen wurden so auf eine 23 µm dicke Polyesterfolie gegossen, daß nach dem Ablüften des Lösungsmittels und Trocknen (3 Minuten bei 80 °C) eine Trockenschichtdicke von 35 µm resultierte. Die so hergestellte photopolymerisierbare Resistschicht wurde bis zur Weiterverarbeitung mit einer Polyethylenfolie abgedeckt. Zur Prüfung wurde die Polyethylenfolie entfernt, der Photoresist bei 80 bis 120 °C auf ein kupferkaschiertes Leiterplattensubstrat auflaminiert und in einem Riston®-PC-Printer bildmäßig mit aktinischem Licht (100 $mJ/cm^2$) belichtet.

Der Kontrast zwischen belichtetem und unbelichtetem Resist war bei Vergleichsbeispiel 1 sehr gut, bei Beispiel 1 und Vergleichsbeispiel 3 gut und bei Vergleichsbeispiel 2 mäßig.

Zur Quantifizierung des Kontrasts wurde in einem weiteren Experiment die optische Dichte der jeweiligen Resistfilme jeweils vor und nach Belichtung ermittelt. Die Messung erfolgte am Extinktionsmaximum des gebildeten Farbstoffs. Die Extinktionszunahme (jeweilige Wellenlänge in Klammern) betrug:

| | |
|---|---|
| Beispiel 1 | 0,13 (605 nm) |
| Vergleichsbeispiel 1 | 0,25 (595 nm) |
| Vergleichsbeispiel 2 | 0,17 (635 nm) |
| Vergleichsbeispiel 3 | 0,12 (605 nm) |

In einem Experiment zur Charakterisierung der Lagerstabilität wurden die Resistfilme 5 Tage bei 50 °C gelagert. Dabei dunkelte Vergleichsbeispiel 1 stark, Vergleichsbeispiel 3 leicht nach, während Beispiel 1 und Vergleichsbeispiel 2 unverändert blieben. Danach wurden die Resiste wie oben beschrieben laminiert und belichtet. Bei Vergleichsbeispiel 1 war kein Kontrast zwischen belichteten und unbelichteten Stellen zu erkennen. Bei Beispiel 1 und Vergleichsbeispiel 2 entsprach der Kontrast dem des nicht gelagerten Resists, während bei Vergleichsbeispiel 3 ein leichter Rückgang des Kontrasts festzustellen war. Mit dem erfindungsgemäßen farbbildenden System wurde also eine Lagerstabilität erreicht, die der bei Verwendung von Malachitgrün-Leukobase entspricht; es wird jedoch ein sehr viel besserer Kontrast erzielt.

Beispiel 2

Eine Gießlösung zur Herstellung eines wäßrig-alkalisch entwickelbaren Photoresistfilms wurde durch Mischen der folgenden Komponenten hergestellt:

| | | |
|---|---|---|
| 1) | 39 %ige Lösung (in Methylethylketon/Isopropanol 1/1) eines Copolymeren aus Styrol (40 %), Methylmethacrylat (10 %), Ethylacrylat (25 %) und Methacrylsäure (25 %) mit einem K-Wert nach Fikentscher von 43,5 | 153,80 g |
| 2) | Trimethylolpropantripropoxytriacrylat | 20,00 g |
| 3) | Tripropylenglykoldiacrylat | 20,00 g |
| 4) | 2,2'-Bis(o-chlorphenyl)-4,4',5,5'-tetra-(p-methoxyphenyl)bisimidazolyl | 1,50 g |
| 5) | N-Methyldiethanolamin | 4,00 g |
| 6) | Methylthioxanthon | 0,80 g |
| 7) | Bis(dimethylaminophenyl)[ethyl(phenyl)-aminophenyl]methan | 0,60 g |
| 8) | Sicometpatentblau 80E131 (C.I. 42 051) | 0,05 g |

Die Lösung wurde auf die beschriebene Weise zu einem Photoresistfilm gegossen. Der erhaltene Resist zeichnet sich durch einen hervorragenden Kontrast aus; die Extinktionszunahme bei 605 nm betrug 0,45. Lagerung bei 50 °C (5 Tage) bewirkte keine Verschlechterung des Kontrasts.

Beispiel 3

Eine Lösung zur Herstellung eines Photoresistfilms wurde durch Mischen der folgenden Komponenten hergestellt:

| | |
|---|---|
| 1) Ethylacetat | 760,00 g |
| 2) Trimethylolpropantriacrylat | 88,00 g |
| 3) äquimolares Umsetzungsprodukt von Bisphenol A-bisglycidylether mit Acrylsäure | 80,00 g |
| 4) Copolymer aus 98 Teilen Methylmethacrylat und 2 Teilen Acrylsäure mit einem mittleren Molekulargewicht von 153.000 (Gewichtsmittel) | 255,00 g |
| 5) 2,2'-Bis(o-chlorphenyl)-4,4',5,5'-tetra(p-methoxpyhenyl)bisimidazolyl | 12,00 g |
| 6) Triethylenglykoldiacetat | 16,00 g |
| 7) Sicometpatentblau 80E131 (C.I. 42 051) | 0,20 g |
| 8) Bis(dimethylaminophenyl)[ethyl(phenyl)aminophenyl]methan | 2,50 g |

Die filtrierte Lösung wurde so auf eine 23 µm dicke Polyesterfolie gegossen, daß nach dem Ablüften und Trocknen (5 min, 95 °C) der Schicht eine Trockenschichtdicke von 35 µm resultierte. Für die Herstellung eines Resistmusters wurde die Resistschicht bei 110 °C auf ein kupferkaschiertes Leiterplattensubstrat auflaminiert und durch ein photographisches Negativ 30 Sekunden in einem Flachbelichter belichtet. Durch die Belichtung wurde die Farbintensität der Schicht vertieft, so daß ein sehr guter Kontrast resultierte. Die Extinktion (bei 605 nm) stieg durch die Belichtung von 0,12 auf 0,92 an. Nach der Belichtung

wurde die Polyesterfolie abgezogen und die Resistschicht an den unbelichteten Stellen mit 1,1,1-Trichlorethan ausgewaschen.

Beispiel 4

Verwendung des erfindungsgemäßen Bilderzeugungsmaterials in Hochdruckplatten. Eine Gießlösung zur Herstellung photopolymerisierbarer Druckplatten wurde auf folgende Weise hergestellt:

| | |
|---|---|
| 1) 33 %ige Lösung (in Wasser) von Mowiol® 04-M1 (Mowiol 04-M1 ist ein Polyethylenoxid-Polyvinylalkohol-Pfropfcopolymer der Fa. Hoechst AG) | 300,00 g |
| 2) 28 %ige Lösung (in Methanol) von 2-Hydroxy-3-phenoxypropylacrylat | 280,00 g |
| 3) Benzildimethylketal | 3,00 g |
| 4) Kaliumsalz des N-Nitrosocyclohexylhydroxylamins | 1,00 g |
| 5) Bis(dimethylaminophenyl)[ethyl(phenyl)aminophenyl]methan | 0,10 g |
| 6) 2,2'-Bis(o-chlorphenyl)-4,4',5,5'-tetraphenylbisimidazolyl | 0,50 g |

Die durch zweistündiges Rühren bei 60 ° C homogenisierte Emulsion wurde auf ein haftungsvermittelnd vorbehandeltes Stahlblech aufgegossen und so abgerakelt, daß nach 1 Stunde Trocknen bei 60 bis 100 ° C eine 0,4 mm dicke photopolymerisierbare Schicht entstand. Nach 2 Tagen Lagerung im Dunkeln wurden die erhaltenen photopolymerisierbaren Druckplatten 4 Minuten durch ein in engem Kontakt auf der lichtempfindlichen Schicht aufliegendes Filmnegativ belichtet. Als Belichtungsgerät wurde ein handelsüblicher Druckplattenbelichter mit 40 Watt-Leuchtstoffröhren mit Emissionsmaximum bei 350 nm als Lichtquelle verwendet. Bei der Belichtung färbten sich die exponierten Stellen intensiv blau, wodurch eine einfache optische Beurteilung des Belichtungserfolges ermöglicht wurde. Nach der Belichtung wurden die nicht exponierten Teile der Photopolymerschicht durch Aussprühen mit Leitungswasser entfernt und die Druckform 30 Minuten bei 80 ° C getrocknet. Die Verwendung des farbgebenden Systems beeinflußte die drucktechnischen Eigenschaften des fertigen Klischees nicht.

## Patentansprüche

**1.** Lichtempfindliches Aufzeichnungsmaterial, im wesentlichen bestehend aus einem Gemisch aus
(a) einem oder mehreren filmbildenden polymeren Bindemitteln,
(b) einem Farbbildnersystem,
(c) gegebenenfalls einer oder mehreren polymerisierbaren mindestens einfach ethylenisch ungesättigten monomeren organischen Verbindungen,
(d) gegebenenfalls einem durch Bestrahlung aktivierbaren Photoinitiator oder Photoinitiatorsystem und
(e) gegebenenfalls üblichen Zusatz- und Hilfsstoffen,
dadurch gekennzeichnet, daß das Aufzeichnungsmaterial als Farbbildnersystem (b) ein Gemisch aus
(b1) einem Photooxidationsmittel,
(b2) einer Leukoverbindung der allgemeinen Formel (I)

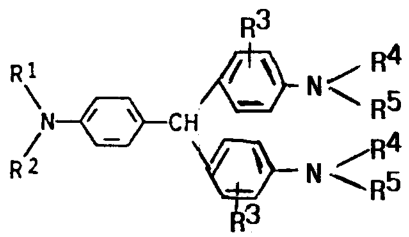

(I)

worin
$R^1$ = Alkyl mit 1 bis 8 Kohlenstoffatomen, Arylalkyl mit 1 bis 6 Kohlenstoffatomen in der Alkylgruppe,
durch OH, Halogen, Nitril, -O-CO-Alkyl mit 1 bis 6 Kohlenstoffatomen in der Alkylgruppe,
-CO-O-Alkyl mit 1 bis 6 Kohlenstoffatomen in der Alkylgruppe substituiertes Alkyl

mit 1 bis 12 Kohlenstoffatomen oder Oxaalkyl mit 3 bis 12 Kohlenstoff- und 1 bis 5 Sauerstoffatomen;

$R^2$ = Phenyl, durch Alkyl mit 1 bis 8 Kohlenstoffatomen, Alkoxy mit 1 bis 8 Kohlenstoffatomen, Nitril, Trifluormethyl oder Halogen ein- oder mehrfach substituiertes Phenyl,

$R^3$ = Wasserstoff, Halogen, Alkyl mit 1 bis 8 Kohlenstoffatomen oder Alkoxy mit 1 bis 8 Kohlenstoffatomen,

$R^4$ und $R^5$ untereinander gleich oder verschieden sind und für Alkyl mit 1 bis 8 Kohlenstoffatomen, Arylalkyl mit 1 bis 6 Kohlenstoffatomen in der Alkylgruppe, wobei der Arylrest durch Halogen, Alkyl mit 1 bis 6 Kohlenstoffatomen oder Alkoxy mit 1 bis 6 Kohlenstoffatomen ein- oder mehrfach substituiert sein kann,
durch OH, Halogen, Nitril, -O-CO-Alkyl mit 1 bis 6 Kohlenstoffatomen im Alkylrest, -CO-O-Alkyl mit 1 bis 6 Kohlenstoffatomen im Alkylrest substituiertes, 1 bis 6 Kohlenstoffatome enthaltendes Alkyl oder Oxaalkyl mit 3 bis 12 Kohlenstoffatomen und 1 bis 5 Sauerstoffatomen stehen, oder $R^4$ zusammen mit $R^5$ ein gesättigtes oder ungesättigtes heterocyclisches Ringsystem bilden,

sowie gegebenenfalls
(b3) einem Sensibilisator enthält.

2. Aufzeichnungsmaterial nach Anspruch 1, dadurch gekennzeichnet, daß es im Farbbildnersystem (b) als Photooxidationsmittel (b1) ein Hexaarylbisimidazolyl der Formel (III) oder einer strukturisomeren Form davon enthält

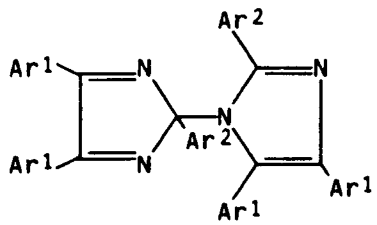

(III)

worin $Ar^1$ für einen substituierten oder unsubstituierten Phenylrest und $Ar^2$ für einen in der 2- oder 2'-Position durch Halogen oder einen Alkylrest substituierten Phenylrest stehen.

3. Aufzeichnungsmaterial nach Anspruch 1, dadurch gekennzeichnet, daß es im Farbbildnersystem (b) als Photooxidationsmittel (b1) ein heteroaromatisches salzartiges System mit mindestens einer Gruppierung der Formel IV enthält

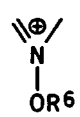

(IV)

worin $R^6$ für einen Alkyl-, Cycloalkyl- oder Arylrest oder einen substituierten Alkyl-, Cycloalkyl- oder Arylrest steht.

4. Aufzeichnungsmaterial nach einem der vorhergehenden Ansprüche, dadurch gekennzeichnet, daß die Leukoverbindung (b2) in einer Menge von 0,01 bis 10 Gew.%, bezogen auf die Gesamtmenge des lichtempfindlichen Aufzeichnungsmaterials enthalten ist.

5. Verfahren zur Herstellung von Hochdruck- oder Tiefdruckplatten, dadurch gekennzeichnet, daß man lichtempfindliches Aufzeichnungsmaterial nach einem der Ansprüche 1 bis 4 einsetzt.

6. Verfahren zur Herstellung von Flachdruckplatten oder Photoresistfilmen, dadurch gekennzeichnet, daß man lichtempfindliches Aufzeichnungsmaterial nach einem der Ansprüche 1 bis 4 einsetzt.

**7.** Verbindung der Formel

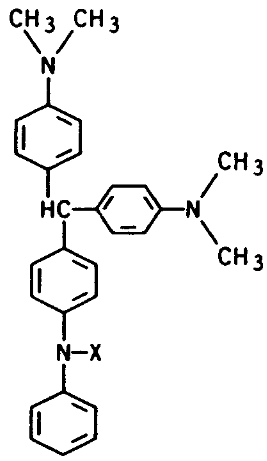

worin X für $C_2H_5$ oder

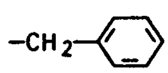

steht,

**8.** Lichtempfindliches Aufzeichnungsmaterial nach einem der Ansprüche 1 bis 4, dadurch gekennzeichnet, daß es als Leukoverbindung (b2) eine Verbindung gemäß Anspruch 7 enthält.

## Claims

**1.** A light-sensitive recording material, consisting essentially of a mixture of
(a) one or more film-forming polymeric binders,
(b) a dye-forming component system,
(c) one or more optional monomeric organic compounds having at least one polymerizable ethylenically unsaturated double bond,
(d) an optional radiation-activatable photoinitiator or photoinitiator system and
(e) customary additives and assistants as optional components,
wherein the dye-forming component system (b) is a mixture of
(b1) a photooxidant,
(b2) a leuco compound of the general formula (I)

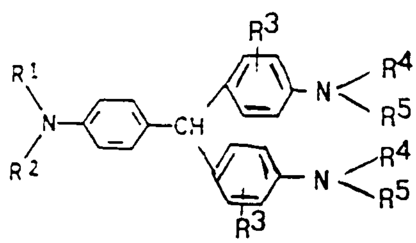

(I)

$R^1$ is alkyl of from 1 to 8 carbon atoms, arylalkyl of from 1 to 6 carbon atoms in the alkyl group, OH-, halogen-, nitrile-, -O-CO-($C_1$-$C_6$-alkyl)- or -CO-O-($C_1$-$C_6$-alkyl)-substituted alkyl of from 1 to 12 carbon atoms or oxaalkyl of from 3 to 12 carbon and from 1 to 5 oxygen atoms,

$R^2$ is unsubstituted phenyl or phenyl which is monosubstituted or polysubstituted by alkyl of from 1 to 8 carbon atoms, alkoxy of from 1 to 8 carbon atoms, nitrile,

trifluoromethyl or halogen,

$R^3$ is hydrogen, halogen, alkyl of from 1 to 8 carbon atoms or alkoxy of from 1 to 8 carbon atoms,

$R^4$ and $R^5$ are identical to or different from each other and each is alkyl of from 1 to 8 carbon atoms, arylalkyl of from 1 to 6 carbon atoms in the alkyl group with the aryl radical being unsubstituted or halogen-, $C_1$-$C_6$-alkyl- or $C_1$-$C_6$-alkoxy-monosubstituted or -polysubstituted, OH-, halogen-, nitrile-, -O-CO-($C_1$-$C_6$-alkyl)- or -CO-O-($C_1$-$C_6$-alkyl)-substituted $C_1$-$C_6$-alkyl or oxaalkyl of from 3 to 12 carbon atoms and from 1 to 5 oxygen atoms,

or $R^4$ together with $R^5$ is a saturated or unsaturated heterocyclic ring system,

and

(b3) a optionally sensitizer.

**2.** A recording material as claimed in claim 1, wherein photooxidant (b1) in the dye-forming component system (b) is a hexaarylbisimidazolyl of the formula (III) or a structurally isomeric form thereof

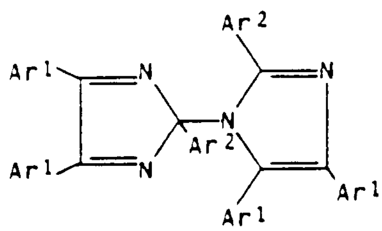

(III)

where $Ar^1$ is substituted or unsubstituted phenyl and $Ar^2$ is phenyl which is substituted in the 2- or 2'-position by halogen or alkyl.

**3.** A recording material as claimed in claim 1, wherein photooxidant (b1) in the dye-forming component system (b) is a heteroaromatic saltlike system containing one or more groups of the formula (IV)

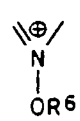

(IV)

where $R^6$ is alkyl, cycloalkyl or aryl or substituted alkyl, cycloalkyl or aryl.

**4.** A recording material as claimed in any of the preceding claims, wherein leuco compound (b2) is present in an amount of from 0.01 to 10 % by weight, based on the total amount of light-sensitive recording material.

**5.** A process for preparing letterpress or intaglio printing plates, which comprises using a light-sensitive recording material as claimed in any of claims 1 to 4.

**6.** A process for preparing lithographic printing plates or photoresist films, which comprises using a light-sensitive recording material as claimed in any of claims 1 to 4.

**7.** A compound of the formula

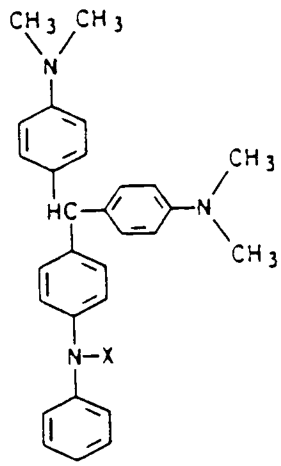

where x is $C_2H_5$ or

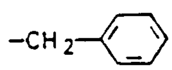

.

**8.** A light-sensitive recording material as claimed in any of claims 1 to 4, wherein leuco compound (b2) is a compound as claimed in claim 7.

**Revendications**

**1.** Matériau d'enregistrement photosensible, essentiellement constitué d'un mélange
(a) d'un ou plusieurs liants polymériques filmogènes,
(b) d'un système formateur de couleur ou chromogène,
(c) éventuellement d'un ou plusieurs composés organiques monomériques comportant au moins une insaturation éthylénique,
(d) éventuellement d'un système photoamorceur ou d'un photoamorceur pouvant être activé par irradiation ou exposition à un rayonnement et
(e) éventuellement d'additifs et d'adjuvants usuels,
caractérisé en ce que le matériau d'enregistrement contient, à titre de système formateur de couleur ou chromogène (b), un mélange
(b1) d'un agent de photooxydation,
(b2) d'un composé leuco de la formule générale (I)

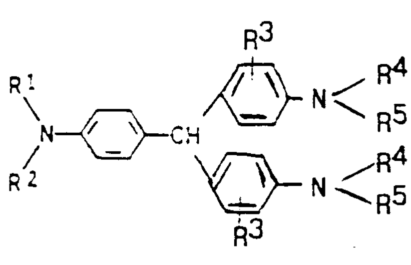

(I)

dans laquelle
$R^1$ représente un radical alkyle qui comporte de 1 à 8 atomes de carbone, un radical arylalkyle dont le radical alkyle comporte de 1 à 6 atomes de carbone, un radical oxaalkyle comportant de 3 à 12 atomes de carbone et de 1 à 5 atomes d'oxygène, ou un radical alkyle comportant de 1 à 12 atomes de carbone, où le radical alkyle est substitué par des atomes d'halogènes, des radicaux OH, nitrile, -O-CO-alkyle dont le radical alkyle comporte de 1 à 6 atomes de carbone, -CO-O-alkyle dont le

radical alkyle comporte de 1 à 6 atomes de carbone;

$R^2$ représente un radical phényle, un radical phényle mono- ou polysubstitué par des radicaux alkyle comportant de 1 à 8 atomes de carbone, alcoxy comportant de 1 à 8 atomes de carbone, nitrile, trifluorométhyle ou des atomes d'halogènes;

$R^3$ représente un atome d'hydrogène, un atome d'halogène, un radical alkyle comportant de 1 à 8 atomes de carbone, ou alcoxy comportant de 1 à 8 atomes de carbone;

$R^4$ et $R^5$ sont mutuellement identiques ou différents et représentent chacun un radical alkyle qui comporte de 1 à 8 atomes de carbone, un radical arylalkyle dont le radical alkyle comporte de 1 à 6 atomes de carbone, où le reste aryle peut être mono- ou polysubstitué par des atomes d'halogènes, des radicaux alkyle comportant de 1 à 6 atomes de carbone, ou alcoxy comportant de 1 à 6 atomes de carbone, un radical oxaalkyle comportant de 3 à 12 atomes de carbone et de 1 à 5 atomes d'oxygène, ou alkyle contenant de 1 à 6 atomes de carbone, substitué par des atomes d'halogènes, des radicaux OH, nitrile, -O-CO-alkyle dont le radical alkyle comporte de 1 à 6 atomes de carbone, -CO-O-alkyle dont le radical alkyle comporte de 1 à 6 atomes de carbone, ou bien $R^4$ forme avec $R^5$ un système hétérocyclique saturé ou insaturé,

comme éventuellement aussi
(b3) d'un sensibilisateur.

2. Matériau d'enregistrement selon la revendication 1, caractérisé en ce qu'il contient dans le système formateur de couleur ou chromogène (b), à titre d'agent de photooxydation (b1), un composé du type hexaarylbisimidazolyle de la formule (III), ou une forme structuralement isomérique d'un tel composé :

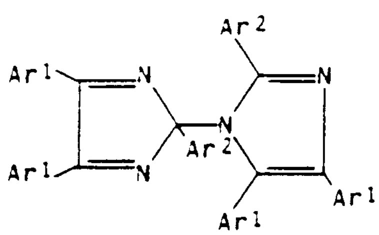

(III)

dans laquelle $Ar^1$ représente un radical phényle substitué ou non substitué et $Ar^2$ représente un radical phényle substitué en position 2 ou en position 2' par un atome d'halogène ou un radical alkyle.

3. Matériau d'enregistrement selon la revendication 1, caractérisé en ce qu'il contient dans le système formateur de couleur ou chromogène (b), à titre d'agent de photooxydation (b1), un système hétéroaromatique salin comportant au moins un groupement de la formule IV :

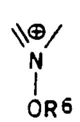

(IV)

dans laquelle $R^6$ représente un radical alkyle, cycloalkyle, ou aryle, ou un radical alkyle, cycloalkyle, ou aryle, substitué.

4. Matériau d'enregistrement suivant l'une quelconque des revendications précédentes, caractérisé en ce qu'il contient le composé du type leuco (b2) en une proportion de 0,01 à 10% en poids, par rapport au poids total du matériau d'enregistrement photosensible.

5. Procédé de préparation de plaques ou clichés pour l'impression typographique ou pour l'impression en héliogravure, caractérisé en ce que l'on utilise un matériau d'enregistrement photosensible suivant l'une quelconque des revendications 1 à 4.

6. Procédé de préparation de films pour photoréserve ou de plaques ou clichés pour l'impression offset, caractérisé en ce que l'on utilise un matériau d'enregistrement photosensible selon l'une quelconque des revendications 1 à 4.

7. Composés de la formule

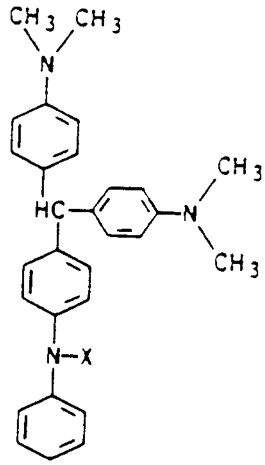

dans laquelle X représente un radical $C_2H_5$ ou

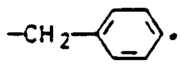

8. Matériau d'enregistrement photosensible selon l'une quelconque des revendications 1 à 4, caractérisé en ce qu'il contient, à titre de composé du type leuco (b2), un composé selon la revendication 7.